(19) Europäisches Patentamt
European Patent Office
Office européen des brevets

(11) Veröffentlichungsnummer: **0 377 190**
**A2**

(12) **EUROPÄISCHE PATENTANMELDUNG**

(21) Anmeldenummer: **89123878.4**

(51) Int. Cl.⁵: **G03F 7/09**

(22) Anmeldetag: **23.12.89**

(30) Priorität: **31.12.88 DE 3844451**

(43) Veröffentlichungstag der Anmeldung:
**11.07.90 Patentblatt 90/28**

(84) Benannte Vertragsstaaten:
**BE DE FR GB NL**

(71) Anmelder: **BASF Aktiengesellschaft**
**Carl-Bosch-Strasse 38**
**D-6700 Ludwigshafen(DE)**

(72) Erfinder: **Naarmann, Herbert, Dr.**
**Haardtblick 15**
**D-6719 Wattenheim(DE)**
Erfinder: **Huemmer, Wolfgang, Dr.**
**Vischerstrasse 16**
**D-6703 Limburgerhof(DE)**

(54) **Photopolymerisierbares System.**

(57) Die Erfindung betrifft ein photopolymerisierbares System, das auf einem dimensionsstabilen Träger mindestens eine photopolymerisierbare Schicht trägt, wobei der dimensionsstabile Träger aus einem elektrisch leitfähigen Polymeren besteht.

Dieses photopolymerisierbare System eignet sich zur Herstellung von Formen.

EP 0 377 190 A2

## Photopolymerisierbares System

Die vorliegende Erfindung betrifft ein photopolymerisierbares System, das zur Herstellung von Formen, beispielsweise von Druckformen für den Flexodruck geeignet ist, die auf einem dimensionsstabilen Träger mindestens eine photopolymerisierbare (reliefbildende) Schicht tragen, die im wesentlichen aus einem Gemisch aus polymerem Bindemittel, mindestens einer ethylenisch ungesättigten polymerisierbaren Verbindung, Photoinitiator und gegebenenfalls thermischem Polymerisationsinhibitor besteht.

Photoempfindliche Polymerzusammensetzungen, die teilverseiftes Polyvinylacetat und ein polyfunktionelles Acrylat oder Methacrylat in Kombination mit die Verträglichkeit verbessernden mehrwertigen Alkoholen enthalten und zur Herstellung von Druckplatten verwendet werden können, sind beispielsweise aus der EP-A-00 81 964 bekannt.

In der EP-A-224 164 werden lichtempfindliche Aufzeichnungsmaterialien beschrieben, die als polymeres Bindemittel verseifte bzw. teilverseifte Pfropfcopolymerisate von Vinylestern auf Polyalkylenoxiden enthalten. Die Verträglichkeit der hierin aufgeführten Monomeren mit dem Bindemittel genügt jedoch in vielen Fällen nicht, um gesteigerte Anforderungen hinsichtlich Bildwiedergabequalität sowie Elastizität daraus hergestellter Druckformen zu erfüllen.

In der EP-A-00 36 301 wird ein lichtempfindliches polyamidharzgemisch aus alkohollöslichem Polyamid, einer nicht polymeren Verbindung, die in ein und demselben Molekül sowohl Vinyl- als auch Epoxygruppen aufweist und mit dem polymeren Bindemittel unter Bildung copolymerisationsfähiger Polymerer reagieren kann, sowie einem polyfunktionellen Vinylmonomeren, das

$-O-CH_2-\underset{OH}{\underset{|}{CH}}-CH_2-O-CO-CR=CH_2$-Gruppierungen

aufweist, beschrieben.

Demnach war die Verwendung von phenylglycidyletheracrylat als weichmachende Komponente, mit polyfunktionellen Acrylaten kombiniert, in photopolymerisierbaren Druckplatten, die alkohollösliches modifiziertes Polyamid als polymeres Bindemittel enthalten, bereits bekannt gewesen.

Derartige Zusammensetzungen sind jedoch wegen des notwendigen Anteils polyfunktioneller Acrylate und der sich daraus ergebenden hohen Vernetzungsdichte nicht zur Herstellung weichelastischer flexotypischer Druckformen geeignet. Darüber hinaus ist die Vrwendung von Alkohol als Entwicklermedium für die Herstellung der Druckform für viele Anwendungsbereiche unerwünscht.

Aufgabe der vorliegenden Erfindung ist es, photopolymerisierbare Systeme aufzuzeigen, die auf elektrisch leitfähige Polymere aufgebracht werden und es ermöglichen, über die leitfähige Matrix elektrische Impulse in die aufpolymerisierte Druckschicht zu geben, wobei die Leitfähigkeit des Trägermaterials definiert eingestellt und partiell variiert werden kann.

Gegenstand der vorliegenden Erfindung ist ein photopolymerisierbares System, das auf einem dimensionsstabilen Träger mindestens eine photopolymerisierbare Schicht trägt, die im wesentlichen aus einem Gemisch aus polymerem Bindemittel, mindestens einer ethylenisch ungesättigten polymerisierbaren organischen Verbindung, Photoinitiator und gegebenenfalls einem Inhibitor gegen die thermische Polymerisation besteht, das dadurch gekennzeichnet ist, daß der dimensionsstabile Träger aus einem elektrisch leitfähigem Polymeren besteht.

Die photopolymerisierbare Schicht dieses photopolymerisierbaren Systems enthält vorzugsweise als ethylenisch ungesättigte polymerisierbare organische Verbindung eine Verbindung der allgemeinen Formel (I)

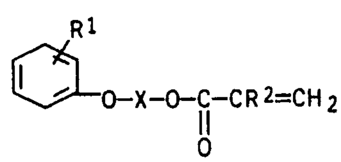

(I)

worin $R^1$ für Wasserstoff, einen Alkylrest mit 1 bis 10 Kohlenstoffatomen oder einen Arylrest mit 6 bis 10 Kohlenstoffatomen,

$R^2$ für Wasserstoff oder einen Methylrest,

und X für $-(CH_2-CH_2-O)_n-C_2H_4-$, $C_2H_4-$,

$-(CHCH_3-CH_2-O)_n-CHCH_3-CH_2-$,

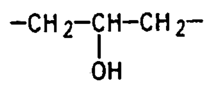 , 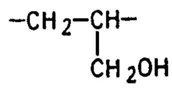 oder 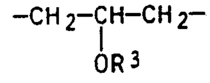

mit $R^3$ = $CH_3$, $C_2H_5$ oder $C_3H_7$ und n = 0 bis 8 stehen.

Als $R^1$ kommt außer Wasserstoff beispielsweise ein Alkylrest mit 1 bis 10 Kohlenstoffatomen, wie z.B. ein Methyl-, Ethyl-, n-Propyl-, Isopropyl-, n-Butyl-, Isobutyl-, tert.-Butyl-, Pentyl-, Hexyl-, n-Octyl-, Isooctylrest oder ein Arylrest, wie z.B. ein Phenyl- oder Naphthylrest in Frage.

Bevorzugte Verbindungen der Formel (I) sind solche, in denen $R^1$ für Methyl oder Wasserstoff und X für den Rest

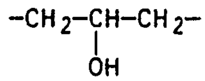 oder $-CH_2-CH_2-$ sowie 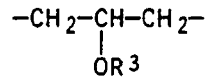

mit $R^3$ = $CH_3$, $C_2H_5$, $C_3H_7$ stehen.

Als polymeres Bindemittel kommen insbesondere wasserlösliche Copolymere oder Derivate des Polyvinylalkohols in Frage, vorzugsweise zumindest teilweise verseifte Pfropfcopolymerisate eines Vinylesters auf Polyethylenoxid oder mit Methacrylsäure teilweise veresterter Polyvinylalkohol und/oder teilacetalisierte Polyvinylalkohole.

Das erfindungsgemäße photopolymerisierbare System kann zusätzlich mindestens eine Zwischenschicht enthalten, die eine Verbindung der allgemeinen Formel (I) in polymerisiertem Zustand enthält, oder auf dem Träger aus elektrisch leitfähigem Polymeren kann als erste Zwischenschicht eine dünne Schicht eines üblichen Haftvermittlers und darauf eine zweite Zwischenschicht vorhanden sein, die eine Verbindung der allgemeinen Formel (I) im Gemisch mit polymerem Bindemittel in polymerisiertem Zustand enthält.

Die photopolymerisierbare Schicht kann auch mit einer abziehbaren Schutzfolie bedeckt sein.

Die photopolymerisierbare Schicht kann ferner mindestens einen Photoinitiator, der bei der Belichtung mit aktinischem Licht eine rasche photopolymerisation in der Schicht auslöst, sowie in bekannter Weise eine bei Belichtung mit aktinischem Licht keine merkliche Photopolymerisation in der Schicht auslösende Kombination eines Farbstoffes mit einem Reduktionsmittel für diesen Farbstoff enthalten, das den Farbstoff in Abwesenheit von aktinischem Licht nicht reduziert, bei Belichtung den Farbstoff im angeregten Elektronenzustand jedoch zu reduzieren vermag.

Bevorzugte Ausführungsformen des erfindungsgemäßen photopolymerisierbaren Systems bestehen auch darin, daß mindestens eine photopolymerisierbare Schicht 5 bis 60 Gew. %, bezogen auf die Gesamtmenge der photopolymerisier baren Schicht, eines elektrisch leitfähigen Polymeren als Abschirmkomponente enthält bzw. daß der Träger aus elektrisch leitfähigem Polymeren die polymerisationsauslösenden Komponenten als Gegenion eingebaut oder adsorptiv gebunden enthält.

Ferner kann der Träger aus elektrisch leitfähigem Polymeren unterschiedliche elektrische Leitfähigkeiten aufweisen.

Das erfindungsgemäße photopolymerisierbare System zeichnet sich überraschenderweise besonders dadurch aus, daß die im elektrisch leitfähigen Polymer-Träger enthaltenen Gegenionen, wie z.B. Wirkstoffe, Sensoren o.ä. definiert in der Menge, durch Anlegen einer elektrischen Spannung (Gleichstrom) und definiert in der Position durch die so strukturierte Form abgeschieden werden können.

Das erfindungsgemäße photopolymerisierbare System ist über die elektrisch leitfähige Trägerfolie aussteuerbar und sowohl als Drucksystem wie auch als Depotmaterial über die in der Trägerfolie enthaltenen Gegenionen geeignet.

Mit den erfindungsgemäßen photopolymerisierbaren Systemen gelingt es, auf einfache und vorteilhafte Weise Druckformen herzustellen, die sich insbesondere für elektrische Impulse über die leitfähige Trägerfolie eignen.

Zu den Aufbaukomponenten des erfindungsgemäßen Systems ist im einzelnen folgendes auszuführen.

Als Träger kommen elektrisch leitfähige Polymere wie Polyacetylen, vorzugsweise Polyheterocyclen wie Polypyrrol, Polythiophen sowie Polyanilin in Betracht. Diese Träger haben im allgemeinen Dicken von ca. 30 bis 250 $\mu$m. Die Herstellung der bevorzugten Materialien ist in Makromol. Chem. Makromol. Symp. 8, 1-15 [1987] beschrieben.

Zwischen Träger- und photopolymerisierbarer Schicht können eine oder mehrere Zwischenschichten vorhanden sein, die als Masken zur Isolierung der darunter liegenden Trägerfolie ausgebildet sind.

Die Trägerfolie kann adsorptiv oder bei den Polyethercyclen auch als Gegenion Komponenten enthalten, die aktiv in den Photopolymerisationsprozeß eingreifen oder als Wirksubstanzen ebenfalls durch elektrische Impulse aus der elektrisch leitfähigen Trägerfolie definiert freigesetzt werden. So kann beispielsweise eine elektrisch leitfähige Trägerfolie, z.B. Polypyrrol, die den photoaktiven Farbstoff als Gegenion enthält und dann mit der üblichen Deckschicht (einseitig) versehen ist - über eine Maske zur definierten Isolation - mit elektrischem Strom beaufschlagt werden. Hierdurch erfolgt ein Freisetzen der Photoinitiatoren, so daß bei der anschließenden Photopolymerisation an den so elektrisch "ausgelagerten" Positionen keine Photopolymerisation erfolgt.

Als Haftlackschichten, deren qualitative und quantitative Zusammensetzung im allgemeinen der Art des Trägermaterials und der Zusammensetzung der reliefbildenden Schicht oder einer weiteren Zwischenschicht angepaßt ist, kann der Träger auch mit einer dünnen Schicht einer Verbindung der Formel (I), vorzugsweise des Phenylglycidylether(meth)acrylats, dem etwas (Photo-)Polymerisationsinitiator beigemischt ist, überzogen und dann thermisch oder durch Belichtung bzw. Bestrahlung polymerisiert werden, wodurch im allgemeinen Haftschichten von 1 bis 100 µm auf dem Träger gebildet werden.

Als weitere, zwischen auf dem Träger angebrachter Haftschicht und photopolymerisierbarer Schicht angeordnete Zwischenschicht eignen sich Gemische aus polymerem Bindemittel und polymerisierbaren ethylenisch ungesättigten Verbindungen, vorzugsweise einer Verbindung der allgemeinen Formel (I), die Polymerisationsinitiatoren bzw. Photopolymerisationsinitiatoren sowie gegebenenfalls weitere übliche Zusatzstoffe, wie Farbstoffe, Weichmacher, Regler und thermische Inhibitoren enthalten, und vor Applikation der photopolymerisierbaren reliefbildenden Schicht thermisch bzw. durch Bestrahlung polymerisiert werden. Derartige Zwischenschichten können 1 bis 200, vorzugsweise 5 bis 100 mm dick sein. Für derartige Zwischenschichten kommen als polymere Bindemittel z.B. die in der Reliefschicht verwendeten wasserlöslichen Polymeren, aber auch z.B. Polyvinylacetate oder Polyvinylacetale und als polymerisierbare ethylenisch ungesättigte Verbindungen z.B. Arylglycidyletheracrylate oder -methacrylate oder Phenoxyethylacrylat oder Mischungen dieser Monomeren mit anderen polymerisierbaren Monomeren, wie z.B. mono- oder polyfunktionellen (Meth)acrylsäureestern in Frage.

Die photopolymerisierbare Schicht besteht erfindungsgemäß aus einem Gemisch aus einem polymeren Bindemittel, mindestens einer ethylenisch ungesättigen polymerisierbaren Verbindung, mindestens einem Photoinitiator und einem Polymerisationsinhibitor, wobei das polymere Bindemittel ein wasserlösliches Vinylalkoholcopolymer oder ein Derivat des Polyvinylalkohols sein kann und als ethylenisch ungesättigte polymerisierbare Verbindung eine Verbindung der allgemeinen Formel (I), vorzugsweise ein Arylglycidyl-(meth)acrylat dient. Die Mitverwendung weiterer ethylenisch ungesättigter copolymerisierbarer insbesondere auch polyfunktioneller Verbindungen ist für die Erzielung befriedigender Ergebnisse nicht erforderlich. Für die Einstellung bestimmter Eigenschaften kann die Mitverwendung weiterer, auch polyfunktioneller copolymerisierbarer Verbindungen von Vorteil sein. Als weitere derartige copolymerisierbare ethylenisch ungesättigte Verbindungen kommen in Frage eine oder mehrere Verbindungen mit mindestens einer photopolymerisierbaren olefinisch ungesättigten Doppelbindung. Hierbei lassen sich die bekannten, für die Herstellung von Reliefformen und Photopolymerhoch-, -tief- und -offsetdruckplatten verwendeten Monomeren, Oligomeren und ungesättigten Polymeren verwenden, deren Art sich nach dem Verwendungszweck der Mischungen, aber auch nach der Art der anderen Mischungskomponenten richtet. In Frage kommen Monomere mit zwei oder mehr olefinisch ungesättigten photopolymerisierbaren Doppelbindungen allein oder in Mischung mit Monomeren mit nur einer olefinisch ungesättigten photopolymerisierbaren Doppelbindung. Auch Polymere mit mehreren seiten- oder endständigen olefinisch ungesättigten Doppelbindungen sind anstelle von oder in Mischung mit den Monomeren verwendbar. Beispiele geeigneter Monomerer sind die Di- und Polyacrylate und -methacrylate, wie sie durch Veresterung von Diolen oder Polyolen mit Acrylsäure oder Methacrylsäure hergestellt werden können; wie die Di- und Tri(meth)acrylate von Ethylenglykol, Diethylenglykol, Triethylenglykol oder Polyethylenglykolen mit einem Molekulargewicht bis etwa 500, 1,2-Propandiol, 1,3-Propandiol, Neopentylglykol, (2,2-Dimethylpropandiol), 1,4-Butandiol, 1,1,1-Trimethylolpropan, Glycerin oder Pentaerythrit, ferner die Monoacrylate und Monomethacrylate solcher Diole und Polyole, wie z.B. Ethylenglykol-, Di-, Tri- oder Tetraethylenglykolmonoacrylat, Monomere mit zwei- oder mehr olefinisch ungesättigten Bindungen, die Urethangruppen und/oder Amidgruppen enthalten, wie die aus aliphatischen Diolen der vorstehend genannten Art, organischen Diisocyanaten und Hydroxyalkyl(meth)acrylaten hergestellten niedermolekularen Verbindungen. Genannt seien auch Acrylsäure, Methacrylsäure sowie deren Derivate wie (Meth)acrylamid, N-Hydroxymethyl(meth)acrylamid oder die (Meth)acrylate von Monoalkoholen mit 1 bis 6 C-Atomen.

Geeignete Monomere sind außerdem Umsetzungsprodukte von Glycidylethern mit Acrylsäure oder Methacrylsäure, wie z.B. Umsetzungsprodukte von Bisphen-A-diglycidylether oder Butandioldiglycidylether mit Acrylsäure oder Methacrylsäure.

Die ethylenisch ungesättigte copolymerisierbare Verbindung der allgemeinen Formel (I) oder das Gemisch dieser Verbindung mit einer oder mehreren weiteren ethylenisch ungesättigten Verbindungen der oben genannten Art werden im allgemeinen in Mengen von 10 bis 70, vorzugsweise 30 bis 60 Gew.%, bezogen auf Gesamtmenge aus polymerem Bindemittel und photopolymerisierbaren Monomeren eingesetzt.

Als polymeres Bindemittel kommen erfindungsgemäß wasserlösliche Vinylalkoholcopolymere und/oder wasserlösliche Derivate des Polyvinylalkohols in Betracht. Beispiele derartiger geeigneter polymerer Bindemittel sind in wäßrigen Lösungsmitteln lösliche oder dispergierbare elastomere Pfropfpolymerisate, die durch Polymerisation von Vinylestern in Gegenwart von Polyalkylenoxiden und einem Initiator der radikalischen Polymerisation, Verseifen oder Teilverseifen des resultierenden Pfropfcopolymerisats und gegebenenfalls anschließendes Verestern oder Umestern von Vinylalkohol-Einheiten des verseiften oder teilverseiften Pfropfcopolymerisats hergestellt sind und im wesentlichen bestehen aus Struktureinheiten der Zusammensetzung

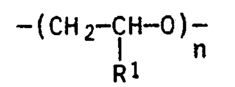 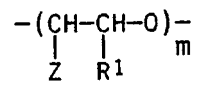 ,

worin Z: aufgepfropfte Seitenzweige mit Struktureinheiten

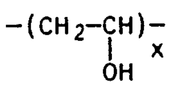 , 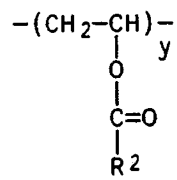 .und ggf. 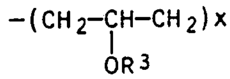

$R^1$ Wasserstoff und/oder Alkylreste mit 1 oder 2 C-Atomen,
$R^2$ Alkyl- und/oder Alkenylreste, gegebenenfalls mit Carboxylsubstituenten,
$R^3$ $CH_3$, $C_2H_5$, $C_3H_7$ darstellen,
und $x > y$, $n > m$, m mindestens 2, $n + m = 20\text{-}2000$, sind

Derartige geeignete Polyvinylalkohole weisen im allgemeinen Molekulargewichte $\overline{M}_n$ zwischen etwa 4 000 und 100 000, vorzugsweise 10 000 und 70 000 auf. Das polymere Bindemittel ist in den erfindungsgemäßen photopolymerisierbaren reliefbildenden Schichten im allgemeinen in Mengen von 30 bis 90, vorzugsweise 40 bis 70 Gew.%, bezogen auf Gesamtmenge aus polymerem Bindemittel und photopolymerisierbaren Monomeren vorhanden.

Die erfindungsgemäßen photopolymerisierbaren Schichten enthalten in üblicher Weise zusätzlich mindestens einen Photoinitiator, im allgemeinen in Mengen von 0,01 bis 10 und insbesondere 0,01 bis 3 Gew.%, bezogen auf die Gesamtmenge der photopolymerisierbaren Schicht. Als Photoinitiatoren sind dabei solche Verbindungen geeignet, die bei Einwirkung von aktinischem Licht Radikale zu bilden vermögen und eine rasche Photopolymerisation in der Schicht auslösen. Als Photoinitiatoren kommen z.B. in Frage Acyloine und Acyloinether, aromatische Diketone und deren Derivate und mehrkernige Chinone. Sehr geeignet sind Benzoin- und $\alpha$-Hydroxymethylbenzoin und besonders deren Alkylether mit 1 bis 8 C-Atomen wie Benzoin-isopropylether, $\alpha$-Hydroxymethyl-benzoinmethylether oder Benzoinmethylether, Benzilmonoketale wie Benzil-dimethylketal, Benzilmethyl-ethylketal, Benzil-methyl-benzylketal, benzil-neopentylketal oder Diarylphosphinoxide, wie sie in der DE-OS 29 09 992 beschrieben sind, vorzugsweise 2,6-Dimethoxybenzoyldiphenylphosphinoxid und insbesondere 2,4,6-Trimethylbenzoyl-diphenylphosphinoxid. Bevorzugt sind Photoinitiatoren in Art und Menge, daß sie für die Auslösung der Photopolymerisation bei bildmäßiger Belichtung mit aktinischem Licht, insbesondere UV-Licht, nur kurze Mindestbelichtungszeiten, bevorzugt nicht mehr als wenige Minuten, benötigen.

Die erfindungsgemäßen photopolymerisierbaren Schichten enthalten außerdem zweckmäßigerweise auch Inhibitoren gegen die thermische Polymerisation, wie Hydrochinon, p-Methoxyphenol, Dinitrobenzol, p-Chinon, Methylenblau, $\beta$-Naphthol, N-Nitrosamine wie N-Nitrosodiphenylamin, Phenothiazin, Phosphorigsäureester wie Triphenylphosphit oder die Salze und insbesondere die Alkali- und Aluminiumsalze des N-Nitroso-cyclohexyl-hydroxylamins. Die Inhibitoren werden den photopolymerisierbaren Mischungen der reliefbildenden polymerisierbaren Schicht im allgemeinen in einer Menge von 0,001 bis 3 Gew.% und insbesondere in einer Menge von 0,003 bis 1 Gew.%, bezogen auf die Gesamtmenge der polymerisierbaren Schicht, zugemischt.

In bekannter Weise können natürlich auch weitere übliche Zusätze mitverwendet werden, wie Weichmachner, gesättigte niedermolekulare Verbindungen mit Amid- oder Alkoholgruppen, Wachse, Pigmente usw.

Gemäß einer besonders vorteilhaften Ausführungsform der vorliegenden Erfindung kann die photopolymerisierbare Schicht noch ein Reglersystem enthalten, wie es beispielsweise in EP-A-114 341 beschrieben ist.

Dies sind Mischungen bestimmter Farbstoffe (1) mit milden Reduktionsmitteln (2) für den mitverwendeten jeweiligen Farbstoff (1) (vgl. auch EP-A-0 114 341). Die Mischung (1) + (2) soll bei der bildmäßigen Belichtung mit aktinischem Licht keine merkliche Photopolymerisation in der Schicht der photopolymerisierbaren Mischung auslösen, was mit wenigen Versuchen feststellbar ist. Beträgt z.B. die Belichtungszeit für erfindungsgemäße, bevorzugt im wesentlichen lösungsmittelfreie, Schichten der photopolymerisierbaren, den Photoinitiator enthaltenden Mischung X Stunden oder Minuten, so sollte die entsprechende Schicht, die den Photoinitiator nicht enthält, mit Vorteil auch bei Anwendung der zehnfachen Belichtungszeit beim anschließenden Entwickeln der Reliefform durch Auswaschen keine merklichen Anteile an photopolymerisierter Schicht aufweisen, im allgemeinen sollten weniger als 20 Gew.% der belichteten Monomerenmengen photopolymerisiert sein.

Als Farbstoffe (1) für die photopolymerisierbaren Mischungen eignen sich vor allem solche aus der Reihe der Phenoxazinfarbstoffe, wie z.B. Capriblau GN (C.I. 51000), Zaponechtblau 3 G (C.I. 51005), Galloblau E (C.I. 51040), Echtneublau 3 R (C.I. 51175), Nilblau A (C.I. 51180), Echtgrün M (C.I. 51210), Echtschwarz L (C.I. 51215), sowie Rhodanilblau, dem Salz bzw. Amid aus Rhodamin B (Basic Violet 10, C.I. 45170) und Nilblau (Basic Blue 12, C.I. 51180), Verbindungen aus der Reihe der Phenaziniumfarbstoffe, wie z.B. Neutralrot (C.I. 50040), Heutralviolett (C.I. 50030), Azinscharlach G (C.I. 50045), Rhodulinheliotrop 3 B (C.I. 50055), Neutralblau C (C.I. 50150), Azingrün GB (C.I. 50155), Safranin B (C.I. 50200), Indaminblau B (C.I. 50204), Rhodulinrot G (C.I. 50215), Rhodulinblau GG extra (C.I. 50220), Indazin GB (C.I. 50221), Safranin T (C.I. 50240), Mauvein (c.I. 50245), Naphthylrot (C.I. 50370) sowie Nigroinschwarz T (C.I. 50415), Acridiniumfarbstoffe, wie z.B. Acriflavin (C.I. 46000), Acridinorange (C.I. 46005), Acridinscharlach J (C.I. 46015), Acridingelb G (C.I. 46025), Aurazin G (C.I. 46030), Diamantphosphin GG (C.I. 46035), Phosphin E (C.I. 46045), Flaveosin (C.I. 46060), Benzoflavin (C.I. 46065) und Rheonin A (C.I. 46075), ferner phenothiaziniumfarbstoffe, wie z.B. Methylenblau oder Thionin. Ebenso eignet sich (Isobutylthio)anthrachinon als Farbstoff (1).

Als Gegenionen zum Einbau in die Polyheterocyclen z.B. Polypyrrol werden solche Farbstoffe verwendet, die zur Anionenbildung, bevorzugt über Sulfosäuregruppen befähigt sind.

Die Auswahl des in der photopolymerisierbaren Mischung verwendeten Farbstoffs (1) wird vor allem vom ästhetischen Eindruck mitbestimmt. So ist z.B. eine visuelle Beurteilung der Druckplatten besonders einfach mit den Verbindungen Neutralrot (C.I. 50040), Safranin T (C.I. 50240) sowie Rhodanilblau, die bevorzugt in der photopolymerisierbaren Mischung verwendet werden.

Die erfindungsgemäßen Schichten können auch in Kombination mit dem Farbstoff ein Reduktionsmittel enthalten, das den mitverwendeten Farbstoff in Abwesenheit von aktinischem Licht nicht reduziert, bei Belichtung den Farbstoff im angeregten Elektronenzustand jedoch reduzieren kann, insbesondere zum Semichinon. Beispiele solcher milden Reduktionsmittel sind Ascorbinsäure, Anethol, Thioharnstoff, Diethylallylthioharnstoff, Hydroxylamin-derivate, insbesondere H-Allylthioharnstoff und bevorzugt Salze des N-Nitrosocyclohexyl-hydroxylamins, insbesondere die Kalium- und Aluminiumsalze. Letztere sind auch als Inhibitoren gegen die thermische Polymerisation in photopolymerisierbaren Mischungen bekannt. Die Menge der zugesetzten Reduktionsmittel beträgt im allgemeinen etwa 0,005 bis 5 und insbesondere 0,01 bis 1 Gew.%, bezogen auf die Gesamtmenge der photopolymerisierbaren Schicht.

Die Herstellung des photopolymerisierbaren Systems erfolgt im allgemeinen durch Aufbringen einer homogenen Mischung der Komponenten der photopolymerisierbaren Schicht, gegebenenfalls unter Zusatz von Lösungsmittel oder Lösungsmittelgemischen auf einen elektrisch leitfähigen Träger, der zweckmäßigerweise vorher mit einer oder mehreren haftvermittelnden Schichten versehen wurde.

Das homogene photopolymerisierbare Gemisch läßt sich auf übliche Weise durch Mischen der Einzelkomponenten in üblichen Mischaggregaten, beispielsweise in Knetern, Extrudern oder Rührkesseln herstellen. Das homogene Gemisch wird dann im allgemeinen in einer Dicke von 25 bis 6000, vorzugsweise 200 bis 1000 µm auf den mit der Haftschicht bzw. mit einer oder mehreren Zwischenschichten versehenen Träger aufgebracht.

Es kann auch vorteilhaft sein, auf die photopolymerisierbare Schicht noch eine Deck- bzw. Schutzschicht aufzubringen, z.B. eine dünne Schicht aus im Entwicklermedium löslichen Polymeren, wie z.B. Polyvinylalkohol oder Polyvinylalkohol-Polyethylenoxid-Copolymerisate.

Die erfindungsgemäßen photopolymerisierbaren Systeme lassen sich in bekannter Weise zu Druckformen verarbeiten. Hierzu wird im allgemeinen die Schicht des photoempfindlichen Materials bildmäßig mit aktinischem Licht aus Lichtquellen, wie UV-Fluoreszenzröhren, Quecksilberhoch-, -mittel- oder -niederdruckstrahlern, Leuchtstoffröhren etc. belichtet, wobei die emittierte Wellenlänge bevorzugt zwischen 300 und 420 nm liegt. Das Entfernen der unbelichteten und unvernetzten Schichtanteile kann durch Sprühen, Waschen, Bürsten etc. mit wäßrigen Lösungsmitteln oder Wasser erfolgen. Es ist ein Vorteil der erfindungsgemäßen Druckplatten, daß sie ein Auswaschen der unbelichteten Schichtteile mit reinem Wasser ohne Zusatz organischer Lösungsmittel erlauben. Zweckmäßig werden entwickelte Formen bei Temperaturen bis zu 120 °C getrocknet und gegebenenfalls gleichzeitig oder danach mit aktinischem Licht nachbelichtet.

Die aus erfindungsgemäßen Aufzeichnungsmaterialien hergestellten Systeme eignen sich für den Druck, zur Wirkstoff-Freigabe und über die elektrisch leitfähige Trägerfolie zu elektrisch beeinflußbaren Systemen.

Die erfindungsgemäßen Systeme, die in der reliefbildenden Schicht eine Verbindung der allgemeinen Formel (I), insbesondere Phenylglycidylether(meth)acrylat als photopolymeriserbare ethylenisch ungesättigte Verbindung enthalten, lassen sich sehr vorteilhaft herstellen und vielseitig, vor allem als elektrisch beeinflußbare Systeme verwenden.

Die Erfindung wird durch die nachstehenden Beispiele erläutert. Die darin genannten Teile und Prozente beziehen sich, soweit nicht anders angegeben, auf das Gewicht. Volumenteile verhalten sich zu Teilen wie Liter zu Kilogramm.

Die Messung der Klischeehärte erfolgte mittels einer Apparatur zur Bestimmung der Brinellhärte (nach DIN 53 456) unter Belastung (Filmhärtebestimmungsapparatur nach Pfund) durch Ausmessen der Eindringtiefe einer Quarzkugel mit einem Durchmesser von 5,926 mm.

Beispiel 1

Durch thermische Polymerisation von 3 Teilen Vinylacetat in Gegenwart von 2 Teilen Polyethylenoxid mit einer mittleren Molmasse von 35 000 g/mol und anschließende Umesterung in methanolischer Natronlauge wird, wie in EP-A-224 164 beschrieben, ein Pfropfcopolymerisat erhalten. Aus 55 Teilen dieses Pfropfcopolymerisats, 45 Teilen Phenylglycidyletheracrylat (= Umsetzungsprodukt aus Phenylglycidylether und Acrylsäure), 1,5 Teilen Benzyldimethylketal, 0,5 Teilen Kaliumsalz des N-Nitrosocyclohexyl-hydroxylamins, 0,05 Teilen Safranin T (C.I. 50 240), 50 Teilen Wasser und 50 Teilen Methanol wird durch Rühren bei 60 °C eine Lösung hergestellt.

Die Lösung wird auf einen mit einem Haftlack versehenen Polypyrrolfilm (65 µm dick) aufgegossen und so abgerakelt, daß nach dem Trocknen eine Schicht der photopolymerisierbaren Mischung von 300 µm Dicke entsteht. Das so erhaltene System wird 4 Minuten mit aktinischem Licht durch ein Negativ belichtet und 2 Minuten bei 20 °C in einem handelsüblichen Sprühwascher mit Wasser entwickelt. Nach dem Trocknen erhält man eine elastische Druckform mit glatter, klebfreier Oberfläche, sehr gutem Relief und einer Brinell-Härte (nach DIN 53 456) von 15 $cN/mm^2$. Der Polypyrrolfilm der als Gegenion Phenylsulfonsäure 30 Gew.% und 5 Gew.% Alkaliblau GB enthält, hat eine elektrische Leitfähigkeit von 35 S/m.

Beispiel 2

Aus einer Lösung von 10 Teilen eines partiell hydrolysierten Polyvinylacetats (Polymerisationsgrad 400, Verseifungsgrad 80 mol.%), dessen freie Hydroxylgruppen mit 5 mol.% Acrylsäure verestert wurden, 50 Teile eines Polyethylenoxid-Polyvinylalkohol-Pfropfcopolymerisats (z.B. Mowiol® 04-M1 der Firma Hoechst), 40 Teilen Phenylglycidyletheracrylat, 1,2 Teilen Benzildimethylketal, 0,5 Teilen Kaliumsalz des N-Nitrosocyclohexyl-hydroxylamins und 0,05 Teilen Safranin T in 50 Teilen Wasser und 50 Teilen Methanol wird, wie in Beispiel 1 beschrieben, eine Druckplatte hergestellt. Der als Träger verwendete Polypyrrolfilm enthielt statt Alkaliblau GB 5 Gew.% 3,7-Diamino-2,8-dimethyl-5-p-Sulfonsäurephenylphenaziniumchlorid.

Nach bildmäßigem Belichten, Entwickeln in Wasser und Trocknen erhält man eine elastische Druckform mit glatter Oberfläche, gut ausgebildetem Relief und einer Brinell-Härte von 35 $cN/mm^2$. Der erhaltene Film hat an der nichtbelichteten Seite eine Leitfähigkeit von 20 S/cm.

Beispiel 3

Aus einer Lösung von 10 Teilen eines partiell hydrolysierten Polyvinylacetats (Polymerisationsgrad 400, Verseifungsgrad 80 mol.%), dessen freie Hydroxylgruppen mit 5 mol.% Acrylsäure verestert wurden, 50 Teile des in Beispiel 1 beschriebenen Polyethylenoxid-Polyvinylalkohol-Pfropfcopolymerisats, 40 Teilen Phenylglycidyletheracrylat, 1,2 Teilen Benzildimethylketal, 0,5 Teilen Kaliumsalz des N-Nitrosocyclohexylhydroxylamins und 0,05 Teilen Safranin T in 50 Teilen Wasser und 50 Teilen Methanol wird, wie in Beispiel 2 beschrieben, eine Platte hergestellt.

Nach bildmäßigem Belichten, Entwickeln in Wasser und Trocknen erhält man eine elastische Druckform mit gut ausgebildetem Relief und einer BrinellHärte von 20 $cN/mm^2$.

Beispiel 4

Eine wie unter Beispiel 1 beschriebene Lösung einer photopolymerisierbaren Mischung wird auf eine mit einer 2 µm dicken Schicht Polyvinylalkohol versehene Polyesterfolie gegossen und so abgerakelt, daß nach dem Trocknen eine 500 µm dicke photopolymerisierbare Schicht entsteht. Auf einen Polypyrrolfilm (100 µm dick) wird Phenylglycidyletheracrylat, das 2 % Benzildimethylketal gelöst enthält, so aufgetragen, daß nach dem Belichten mit aktinischem Licht eine 50 µm dicke Schicht des polymerisierten Acrylats entsteht.

Durch Kaschieren der photopolymeren Schicht mit dem so präparierten Träger, unter Verwendung einer Mischung von Ethanol und Wasser im Verhältnis 1:1, und Abziehen der Polyesterfolie, wird eine Druckplatte hergestellt, aus der nach dem oben beschriebenen Verfahren Druckformen mit ausgezeichneter Haftung zwischen Reliefschicht und Träger erhalten werden. Der Polypyrrolfilmträger hat an der nichtbelichteten Fläche eine Leitfähigkeit von 25 S/cm.

Beispiel 5

Es wird verfahren wie unter Beispiel 4 beschrieben, jedoch wird anstelle der Polypyrrolfolie eine 20 µm dicke Polyacetylenfolie als Träger verwendet. Auch hier werden Druckformen mit ausgezeichneter Haftung zum Träger erhalten.

Beispiel 6

Es wird wie in Beispiel 1 beschrieben gearbeitet, jedoch ein Polypyrrolfilm verwendet, der statt 5 Gew.% Alkaliblau jetzt 5 Gew.% Monobactamaztreonam (Lit. Chemistry in Britain Ap. 1983, Seite 302) enthält.

Zur Herstellung einer Form aus der so hergestellten Rohplatte ist eine Belichtungszeit von mehr als 25 Minuten notwendig.

Man erhält so harte Formen mit rauher Oberfläche.

Beispiel 7

Es wird wie in Beispiel 1 beschrieben gearbeitet, jedoch ein Polypyrrolfilm verwendet, der 25 Gew.% Iodhydroxychinolinsulfonsäure als Gegenion enthält. Filmdicke 70 µm, Leitfähigkeit 15 S/cm.

Beispiel 8

Es wird wie in Beispiel 1 beschrieben gearbeitet, jedoch ein Polypyrrolfilm verwendet, der 30 Gew.% Lucifergelb CH und 5 Gew.% Phenylsulfonsäure enthält. Filmdicke 80 µm, Leitfähigkeit 55 S/cm.

Beispiel 9

Jeweils Filme von 10 x 10 cm Größe der nach den Beispielen 1 bis 8 hergestellten Systeme werden über die elektrisch leitfähige Trägerfolie als Kathode geschaltet und mit einer Stromdichte [i] von 10

$mA/cm^2$ beaufschlagt, als Elektrolyt dient ein wäßriges Gel von 10 Gew.% Polyvinylpyrrolidon mit 0,5 Gew.% $Na_2HPO_4$ sowie 0,1 Gew.% Na zitrat, die Kathode wird mit 0,8 bis 1 mm des Elektrolytgels bestrichen und auf die als Anode geschaltete Oberfläche appliziert. Innerhalb von 20 Minuten werden jeweils ca. 60 % der in dem Polypyrrolfilm enthaltenen Gegenionen auf der Anode - entsprechend dem durch das erfindungsgemäße Verfahren aufgebrachten Muster - abgeschieden.

Das Elektrolytgel wurde jeweils auf die mit der Reliefform versehene Seite des erfindungsgemäßen Systems aufgetragen.

## Ansprüche

1. Photopolymerisierbares System, das auf einem dimensionsstabilen Träger mindestens eine photopolymerisierbare Schicht trägt, die im wesentlichen aus einem Gemisch aus polymerem Bindemittel, mindestens einer ethylenisch ungesättigten polymerisierbaren organischen Verbindung, Photoinitiator und gegebenenfalls einem Inhibitor gegen die thermische Polymerisation besteht, dadurch gekennzeichnet, daß der dimensionsstabile Träger aus einem elektrisch leitfähigen Polymeren besteht.

2. Photopolymerisierbares System nach Anspruch 1, dadurch gekennzeichnet, daß die photopolymerisierbare Schicht als ethylenisch ungesättigte polymerisierbare organische Verbindung eine Verbindung der allgemeinen Formel (I) enthält,

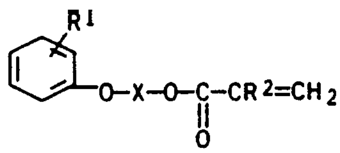 (I)

worin $R^1$ für Wasserstoff, einen Alkylrest mit 1 bis 10 Kohlenstoffatomen oder einen Arylrest mit 6 bis 10 Kohlenstoffatomen,
$R^2$ für Wasserstoff oder einen Methylrest,
und X für $-(CH_2-CH_2-O)_n-C_2H_4-$, $-C_2H_4-$,
$-(CHCH_3-CH_2-O)_n-CHCH_3-CH_2-$,

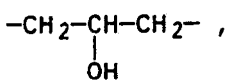 , 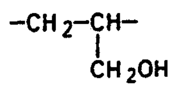 oder 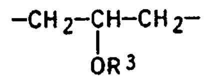

mit $R^3 = CH_3$, $C_2H_5$ oder $C_3H_7$
und n = 0 bis 8 stehen.

3. Photopolymerisierbares System nach einem der vorhergehenden Ansprüche, dadurch gekennzeichnet, daß die photopolymerisierbare Schicht als polymeres Bindemittel ein wasserlösliches Copolymer oder Derivat des Polyvinylalkohols enthält.

4. Photopolymerisierbares System nach Anspruch 2 oder 3, dadurch gekennzeichnet, daß es zusätzlich mindestens eine Zwischenschicht enthält, die eine Verbindung der allgemeinen Formel (I) in polymerisiertem Zustand enthält.

5. Photopolymerisierbares System nach Anspruch 4, dadurch gekennzeichnet, daß auf dem Träger aus elektrisch leitfähigem Polymeren als erste Zwischenschicht eine dünne Schicht eines üblichen Haftvermittlers und darauf eine zweite Zwischenschicht vorhanden ist, die eine Verbindung der allgemeinen Formel (I) im Gemisch mit polymerem Bindemittel in polymerisiertem Zustand enthält.

6. Photopolymerisierbares System nach einem der vorhergehenden Ansprüche, dadurch gekennzeichnet, daß die photopolymerisierbare Schicht mit einer abziehbaren Schutzfolie bedeckt ist.

7. Photopolymerisierbares System nach einem der Ansprüche 2 bis 6, dadurch gekennzeichnet, daß in der Formel (I) $R^1$ für Wasserstoff oder Methyl und X für den Rest $-CH_2-CH(OH)-CH_2-$ stehen.

8. Photopolymerisierbares System nach einem der Ansprüche 3 bis 7, dadurch gekennzeichnet, daß als wasserlösliches Copolymer des Polyvinylalkohols ein zumindest teilweise verseiftes Pfropfcopolymerisat eines Vinylesters auf Polyethylenoxid eingesetzt wird.

9. Photopolymerisierbares System nach einem der Ansprüche 3 bis 7, dadurch gekennzeichnet, daß als wasserlösliches Derivat des Polyvinylalkohols ein mit Methacrylsäure teilweise veresterter Polyvinylalkohol

und/oder ein teilacetalisierter Polyvinylalkohol eingesetzt wird.

10. photopolymerisierbares System nach einem der vorhergehenden Ansprüche, dadurch gekennzeichnet, daß die photopolymerisierbare Schicht mindestens einen photoinitiator, der bei der Belichtung mit aktinischem Licht eine rasche photopolymerisation in der Schicht auslöst, sowie eine bei Belichtung mit aktinischem Licht keine merkliche photopolymerisation in der Schicht auslösende Kombination eines Farbstoffes mit einem Reduktionsmittel für diesen Farbstoff enthält, das den Farbstoff in Abwesenheit von aktinischem Licht nicht reduziert, bei Belichtung den Farbstoff im angeregten Elektronenzustand jedoch zu reduzieren vermag.

11. Photopolymerisierbares System nach einem der vorhergehenden Ansprüche, dadurch gekennzeichnet, daß mindestens eine photopolymerisierbare Schicht 5 bis 60 Gew.%, bezogen auf die Gesamtmenge der photopolymerisierbaren Schicht, eines elektrisch leitfähigen Polymeren als Abschirmkomponente enthält.

12. Photopolymerisierbares System nach Anspruch 10 oder 11, dadurch gekennzeichnet, daß der Träger aus elektrisch leitfähigem Polymeren die polymerisationsauslösenden Komponenten als Gegenion eingebaut oder adsorptiv gebunden enthält.

13. Photopolymerisierbares System nach einem der vorhergehenden Ansprüche, dadurch gekennzeichnet, daß der Träger aus elektrisch leitfähigem Polymeren unterschiedliche elektrische Leitfähigkeiten aufweist.